# EUROPEAN PATENT APPLICATION

(11) **EP 1 930 588 A2**
(43) Date of publication of application: **11.06.2008**
(21) Application number: 07122386.1
(22) Date of filing: 05.12.2007
(51) Int. Cl.: F03G 7/00

(54) **Actuator based on a hetero-Junction membrane**

(30) Priority: 05.12.2006 KR 20060122640; 26.06.2007 KR 20070063121
(71) Applicant: Electronics and Telecommunications Research Institute, Daejeon-city (KR)
(72) Inventor: Park, Jonghyurk, Daegu-city (KR); Kim, Eunkyoung, Daejeon-city (KR); Moon, Seungeon, Daejeon-city (KR); Lee, Hong-Yeol, Cheongju-city, Choongcheongbuk-do (KR); Park, Kang-Ho, Daejeon-city (KR); Kim, Jong Dae, Seo-gu, Daejeon-city (KR); Kim, Gyu-Tae, Seoul (KR); Lee, Kang-Ho, Seoul (KR); Lee, Seong-Min, Seoul (KR)
(74) Representative: Betten & Resch

(57) **Abstract**

Provided is a hetero-junction membrane including: a first layer comprising first nanoparticles of a first conductive type; and a second layer comprising second nanoparticles of a second conductive type, wherein the first layer and the second layer are joined to each other. The hetero-junction membrane has advantages in that actuating efficiency is much higher, the direction of actuating can be predicted and the manufacturing processes are simple compared to conventional bucky paper formed of a single layer.

## Description

### CROSS-REFERENCE TO RELATED PATENT APPLICATION

This application claims the benefit of Korean Patent Application No. 10-2006-0122640, filed on December 5, 2006 and Korean Patent Application No. 10-2007-0063121, filed on June 26, 2007 in the Korean Intellectual Property Office, the disclosure of which are incorporated herein in their entirety by reference.

### BACKGROUND OF THE INVENTION

### 1 Field of the Invention

The present invention relates to a hetero-junction membrane and a method of preparing the same, and more particularly, to a hetero-junction membrane in which actuating efficiency is more excellent and actuating direction is predictable compared to conventional bucky paper formed of a single membrane and a method of preparing the same. This work was supported by the IT R&D program of MIC/IITA [2006-S-006-01, Components/Module technology for Ubiquitous Terminals]

### 2. Description of the Related Art

Unlike materials in a bulk state, nanowires have a very large specific surface area (area per unit volume), and thus physical, chemical, optical, mechanical, electrical and thermal properties and efficiency of nanowires are significantly different from conventional materials. In terms of a part of the properties described above, nanowires exhibit preferable properties that cannot be predicted from conventional materials in a bulk state. Thus, nanowires are expected to be applied in a variety of fields.

Particularly, carbon nanotubes are thought to have enormous potential due to excellent electroconductivity and high mechanical strength. In addition, it has been reported that carbon nanotubes can be used as inner wires, and the like of field emission display devices, field effect electronic devices, hydrogen storage, miniature semiconductor devices, sensors, probes, and circuits,

In addition, vanadium pentoxide (V₂O₅) nanowires can be synthesized through a process other than through a severe and complex synthesis process at a high temperature and a high pressure, which is needed for synthesizing conventional nanowires. Due to these advantages, V₂O₅ nanowires have drawn much attention. That is, V₂O₅ nanowires can easily be synthesized by sol-gel synthesis at room temperature and atmospheric pressure. In addition, V₂O₅ nanowires are in the form of a rectangular parallelepiped, not in the form of a cylinder and also have a very high aspect ratio, and thus they are expected to be applied in a variety of fields in the future

It has become known that such nanowires are formed in the form of bucky paper, and thus can be applied as an actuator. When a voltage is applied to a nanowire bucky paper actuator, each of the nanowires is expanded so that the lengths of the nanowires are changed. The lengths of the nanowires change because ions are absorbed to or dissociated from the nanowires of bucky paper by an electric potential difference, and thus the nanowires are bent towards any one direction.

Conventional ferroelectric-based actuators can convert electric energy to mechanical energy only when a high voltage is applied thereto. On the other hand, nanowire bucky paper actuators can convert electric energy to mechanical energy even when a low voltage is applied thereto, and they have high power. In addition, the manufacturing processes are very simple so that nanowire bucky paper actuators can be mass produced.

However, conventional nanowire bucky paper actuators do not have very high actuating efficiency and the actuating direction thereof cannot be predicted. That is, when an electric potential is applied to a nanowire bucky paper actuator, the displacement of the bucky paper is not very large, and when an electric field with a specific direction is applied to the actuator, the bending direction of the bucky paper cannot be predicted. Therefore, there is a high need for solving problems described above.

### SUMMARY OF THE INVENTION

The present invention provides a hetero-junction membrane in which actuating efficiency is more excellent and actuating direction is predictable compared to conventional bucky paper formed of a single membrane.

The present invention also provides a method of easily preparing the hetero-junction membrane having excellent actuating efficiency and predictable actuating direction

The present invention also provides an actuator including the hetero-junction membrane having excellent actuating efficiency and predictable actuating direction.

According to an aspect of the present invention, there is provided a hetero-junction membrane comprising: a first layer comprising first nanoparticles of a first conductive type, and a second layer comprising second nanoparticles of a second conductive type, wherein the first layer and the second layer are joined to each other

The first conductive type may be n-type, and the second conductive type may be p-type

An aspect ratio of the first nanoparticles and the second nanoparticles may be preferably 30 or more, and more preferably 50 or more

Optionally, the first nanoparticles may be V₂O₅, and the second nanoparticles may be carbon nanotubes. Particularly, the carbon nanotubes may be multiwall carbon nanotubes (MWCNTs).

According to another aspect of the present invention, there is provided a method of preparing a hetero-junction membrane, the method comprising: preparing a first dispersion comprising first nanoparticles of a first conductive type; preparing a second dispersion comprising second nanoparticles of a second conductive type; removing a dispersion medium from the first dispersion to form a first layer comprising the first nanoparticles; and positioning the second dispersion on the first layer and removing a dispersion medium from the second dispersion to form a second layer comprising the second nanoparticles.

The first conductive type may be n-type, and the second conductive type may be p-type

Particularly, the first nanoparticles may be V₂O₅, and the second nanoparticles may be carbon nanotubes.

Optionally, the removing of the dispersion medium from the first dispersion to form the first layer comprising the first nanoparticles may comprise passing the first dispersion through a filter to remove a dispersion medium therefrom.

The positioning of the second dispersion on the first layer and the removing of the dispersion medium from the second dispersion to form a second layer comprising the second nanoparticles may comprise dripping the second dispersion on the first layer in a state in which the pressure at a lower portion of the filter is lower than the pressure at an upper portion of the first layer.

Optionally, the method of preparing the hetero-junction membrane may further comprise baking a laminated structure of the first layer and the second layer at a temperature of 60 to 100°C after the forming of the second layer.

According to another aspect of the present invention, there is provided an actuator comprising the hetero-junction membrane.

### BRIEF DESCRIPTION OF THE DRAWINGS

The above and other features and advantages of the present invention will become more apparent by describing in detail exemplary embodiments thereof with reference to the attached drawings in which
FIG. 1A is a view of a hetero-junction membrane according to an embodiment of the present invention;
FIG. 1B is an enlarged view of a portion of a cross-section of the interface of a hetero-junction membrane according to an embodiment of the present invention;
FIGS. 2A through 2C are conceptional views which sequentially illustrate a method of preparing a hetero-junction membrane according to an embodiment of the present invention;
FIG. 3 is a conceptional view showing an experimental device for verification of actuating properties of a hetero-junction membrane of the present invention;
FIG. 4 is a view showing a actuating direction of a hetero-junction membrane of the present invention; and
FIGS. 5A and 5B are graphs showing test results of actuating efficiencies of a hetero-junction membrane of Example and a bucky paper of Comparative Example.

### DETAILED DESCRIPTION OF THE INVENTION

Hereinafter, exemplary embodiments of the present invention will be described with reference to the accompanying drawings. However, the present invention may be embodied in many different forms and should not be construed as being limited to embodiments set forth herein. Rather, these embodiments are provided so that this disclosure will be thorough and complete, and will fully convey the scope of the invention to those skilled in the art. The same reference numerals refer to the same constitutional elements throughout the drawings. Further, a variety of elements and regions in the drawings are schematically illustrated. Thus, the present invention is not limited to the relative sizes or intervals shown in the accompanying drawings In addition, the term "first, second,.." is used in order to describe a layer, that is, a constitutional element of the present invention, however, the present invention is not limited thereto The term "first, second,.." is used only for the purpose of distinction, and even if a first layer is referred to as a second layer and a second layer is referred to as a first layer, this does not depart from the scope of the present invention.

The present invention provides a hetero-junction membrane which includes a first layer comprising first nanoparticles of a first conductive type; and a second layer comprising second nanoparticles of a second conductive type, wherein the first layer and the second layer are joined to each other

The first conductive type may be n-type. The second conductive type may be p-type. Alternatively, the first conductive type and the second conductive type may be n-type and p-type, respectively.

The larger the aspect ratio of the first nanoparticles is, the more bucky paper formed of the first nanoparticles is bent, and thus the larger the aspect ratio the better. The aspect ratio of the first nanoparticles may be preferably at least 30, and more preferably at least 50.

The first layer may be formed of only the first nanoparticles, however, may further optionally comprise a binder which binds the first nanoparticles. The binder may be a polymer such as polyvinylalcohol, polyacrylonitrile, a phenol resin, polytetrafluoroethylene (PTFE), polyvinylidenefluoride, a polyvinylidenefluoridehexafluoropropylene copolymer (PVdF-HFP), or cellulose acetate. However, although the first layer does not comprise the binder, since the aspect ratio of the first nanoparticles is very large, the first nanoparticles can obtain sufficient binding force by being entangled with each other.

The first nanoparticles may be any n-type nanoparticles, for example, vanadium oxide (V₂O₅), zinc oxide (ZnO₂), tin oxide (SnO₂), and the like, but the present invention is not limited thereto.

Also, the larger the aspect ratio of the second nanoparticles is, the more bucky paper formed of the second nanoparticles is bent, and thus the larger the aspect ratio the better. The aspect ratio of the second nanoparticles may be preferably at least 30, and more preferably at least 50.

The second layer may also be formed of only the second nanoparticles, however, may further optionally comprise a binder which binds the second nanoparticles. The binder may be the polymer as described above in the case of the first layer. However, although the second layer does not comprise the binder, since the aspect ratio of the second nanoparticles is very large, the second nanoparticles can obtain sufficient binding force by entangling with each other.

The second nanoparticles may be any p-type nanoparticles, for example, carbon nanotubes, and the like, but the present invention is not limited thereto In particular, the carbon nanotubes may be multiwall carbon nanotubes (MWCNTs).

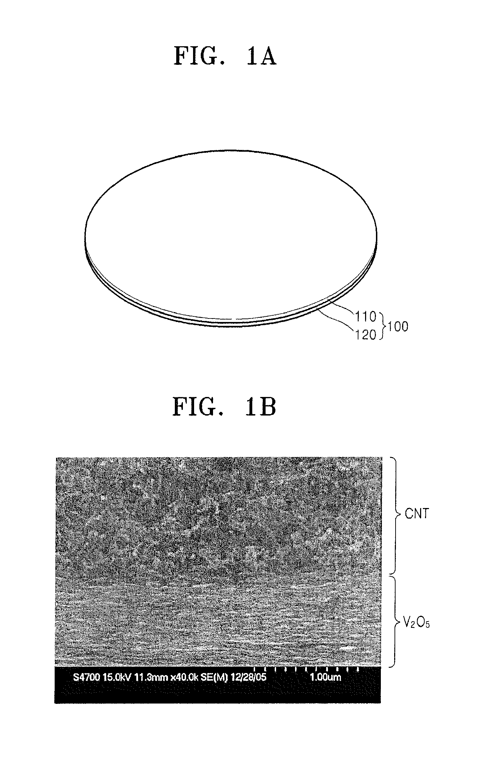

FIG. 1A is a view of a hetero-junction membrane 100 according to an embodiment of the present invention, wherein the hetero-junction membrane 100 has a structure in which a first layer 110 formed of V₂O₅ and a second layer 120 formed of carbon nanotubes are sequentially formed. FIG. 1B is an enlarged view of a cross-section of the hetero-junction membrane 100 of FIG. 1A. Referring to FIG.1B, it can be seen that the carbon nanotubes are entangled with each other and V₂O₅ is entangled with each other.

Hereinafter, a method of preparing the hetero-junction membrane will be described.

The present invention also provides a method of preparing the hetero-junction membrane, the method including preparing a first dispersion comprising first nanoparticles of a first conductive type; preparing a second dispersion comprising second nanoparticles of a second conductive type; removing a dispersion medium from the first dispersion to form a first layer comprising the first nanoparticles; and positioning the second dispersion on the first layer and removing a dispersion medium from the second dispersion to form a second layer comprising the second nanoparticles.

The first dispersion is a mixture in which the first nanoparticles are dispersed in a dispersion medium, and the second dispersion is a mixture in which the second nanoparticles are dispersed in a dispersion medium. The dispersion medium may be any liquid which can disperse each of the first and second nanoparticles, but is not particularly limited. For example, the dispersion medium may be water, alcohols such as methanol, ethanol, isopropylalcohol, n-propylalcohol, and butylalcohol, dimethylacetamide (DMAc), dimethylformamide, dimethylsulfoxide (DMSO), N-methylpyrrolidone, and tetrahydrofurane, but the present invention is not limited thereto.

An amount ratio of the first dispersion to the first nanoparticles and an amount ratio of the second dispersion to the second nanoparticles are not particularly limited.

The dispersion medium is removed from the prepared first dispersion to form the first layer comprising the first nanoparitcles. The removing of the dispersion medium from the first dispersion is not particularly limited.

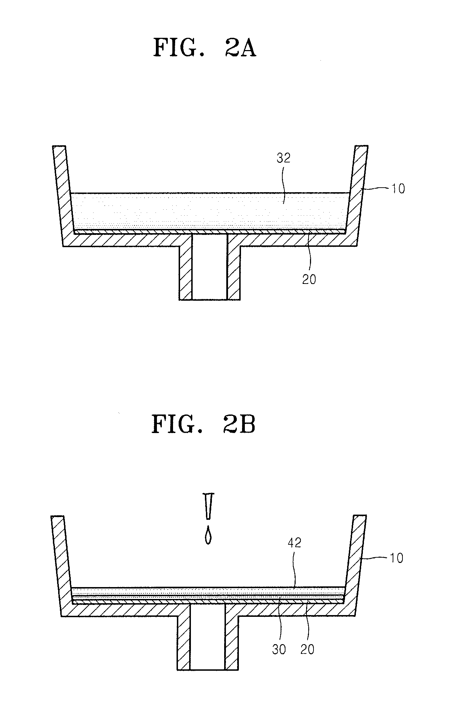

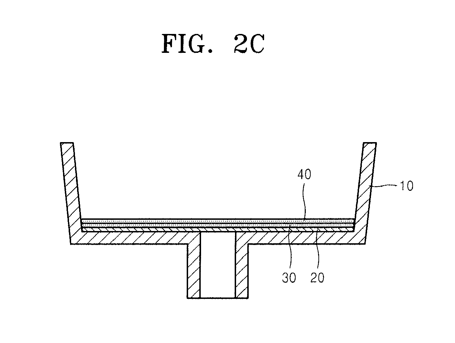

FIG. 2A is a view illustrating a process of removing a dispersion medium from a first dispersion in a method of preparing a hetero-junction membrane, according to an embodiment of the present invention. Referring to FIG. 2A, a filter 20 is positioned in a funnel 10, a first dispersion 32 is poured in the funnel 10, and then first nanoparticles are filtered therein To rapidly remove a dispersion medium from the first dispersion 32, a pressure difference may be generated between an upper portion of the filter 20 and a lower portion of the filter 20. That is, by decreasing the pressure in the lower portion of the filter 20 or increasing the pressure in the upper portion of the filter 20, the dispersion medium is rapidly removed from the first dispersion 32 to form a first layer.

However, the removing of the dispersion medium from the first dispersion is not limited thereto, and for example, may be performed by heat treatment under pressure.

Thereafter, a second dispersion is positioned on the first layer and a dispersion medium is removed from the second dispersion to form a second layer comprising the second nanoparticles.

FIG. 2B is a view illustrating the process described above. Referring to FIG. 2B, a second dispersion 42 is poured on the first layer 30, and then a dispersion medium is removed from the second dispersion 42. The dispersion medium may be rapidly removed from the second dispersion 42 by forming a pressure difference between the upper portion of the first layer 30 and the lower portion of the filter 20, as described in the process of forming the first layer 30.

Optionally, the second dispersion 42 may be dripped on the first layer 30 little by little. If the second dispersion 42 is poured on the first layer 30 all at once as in the process of forming the first layer 30, the first nanoparticles constituting the first layer 30 may be diffused into the dispersion medium of the second dispersion 42. Thus, to avoid this, the second dispersion 42 may instead be dripped little by little.

Optionally, the second dispersion 42 may be removed by heat treatment under reduced pressure.

Thereafter, to completely remove the dispersion medium and other impurities, baking may be further optionally performed That is, after the first layer is formed and the second layer is formed thereon, the first and second layers are separated from the filter, and then heated in a heating space such as an oven. As a result, the first and second layers are baked. The baking may be performed at a temperature of about 60 to about 100 °C. In addition, the baking may be performed for about 3 to about 20 hours.

The present invention also provides an actuator including the hetero-junction membrane. The actuator is lighter and has excellent actuating properties compared to known microelectromechanical systems (MEMS)-based actuators, and thus it can be used for a variety of uses. The actuator is not particularly limited, and for example, can be applied in any kind of mechanical device which requires precision control, artificial muscles, information storage devices, and/or data reading devices.

Hereinafter, the configuration and effect of the present invention will be described more specifically with reference to the following Example and Comparative Example. The following examples are only for illustrative purposes and are not intended to limit the scope of the invention.

### <Example>

Ammonium metavanadate (NH₄VO₃) (manufactured by Aldrich) was added to deionized water together with an acid ion exchange resin (DOWEX 50WX8-100, manufactured by Aldrich), and the mixture was reacted at 24 °C to obtain vanadium pentoxide nanowires.

Thereafter, the vanadium pentoxide nanowires were dispersed in ethanol to prepare a first dispersion.

In addition, multiwall carbon nanotubes were dispersed in ethanol to prepare a second dispersion.

A nitrocellulose easter (NCE) filter was positioned in a funnel, and then the first dispersion was passed through the filter. Herein, the pressure in a lower portion of the NCE filter was decreased to remove ethanol as quickly as possible.

After ethanol of the first dispersion was fully removed through the NCE filter to form a first layer, the second dispersion was slowly added on the first layer. Herein, ethanol was removed from the second dispersion while being added. As a result, a second layer formed of carbon nanotubes was formed on the first layer formed of vanadium pentoxide.

Next, the first and second layers were separated from the NCE filter with caution, and then put in an oven and baked at 80 °C for 12 hours to prepare a hetero-junction membrane.

### <Comparative Example>

Vanadium pentoxide nanowires were prepared in the same manner as in Example. Then, the vanadium pentoxide nanowires were dispersed in ethanol to prepare a dispersion.

A nitrocellulose easter (NCE) filter was positioned in a funnel, and then the dispersion was passed through the filter. Herein, the pressure in a lower portion of the NCE filter was decreased to remove ethanol as quickly as possible. As a result, a vanadium pentoxide layer was formed

Next, the vanadium pentoxide layer was separated from the NCE filter with caution, and then put in an oven and baked at 80 °C for 12 hours to prepare a vanadium pentoxide bucky paper.

### <Prediction of actuating direction>

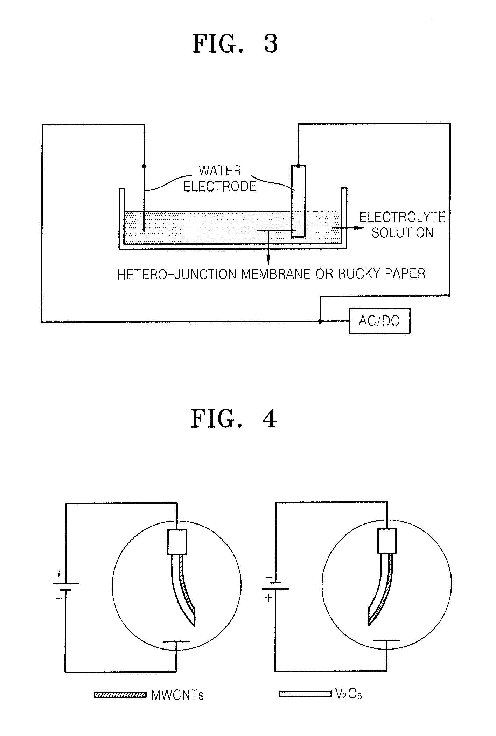

An actuator as illustrated in FIG. 3 was made using each of the hetero-junction membrane and the vanadium pentoxide bucky paper. Then, an electric potential was applied to an electrolyte solution. As a result, a certain rule in displacement of the hetero-junction membrane according to the direction of an electric field was found, as illustrated in FIG. 4. That is, when a positive (+) electric potential was applied to an electrode with the hetero-junction membrane attached thereto, the hetero-junction membrane was bent towards the second layer formed of carbon nanotubes. On the other hand, when a positive (+) electric potential was applied to a counter electrode, the hetero-junction membrane was bent towards the opposite direction.

The bucky paper of Comparative Example showed a constant actuating direction with respect to the direction of an electric potential. However, what the direction was could not be determined. In addition, actuating directions vary depending on conditions of manufacturing actuators, and the fact that substantial prediction of the actuating direction is impossible is known to those of ordinary skill in the art.

### <Actuating efficiency>

As shown in FIG. 3, one end of the hetero-junction membrane of Example was fixed to the electrode and the other end thereof near to the counter electrode was able to move. The center line of the hetero-junction membrane was positioned to correspond to an imaginary line that connects the electrode and the counter electrode and then by applying an electric potential thereto, the extent of displacement of the other end of the hetero-junction membrane near to the counter electrode from the imaginary line was measured. The displacement was normalized by being divided by the length of the hetero-junction membrane. Herein, the length of the hetero-junction membrane was a length measured in the direction of the line connecting the two electrodes.

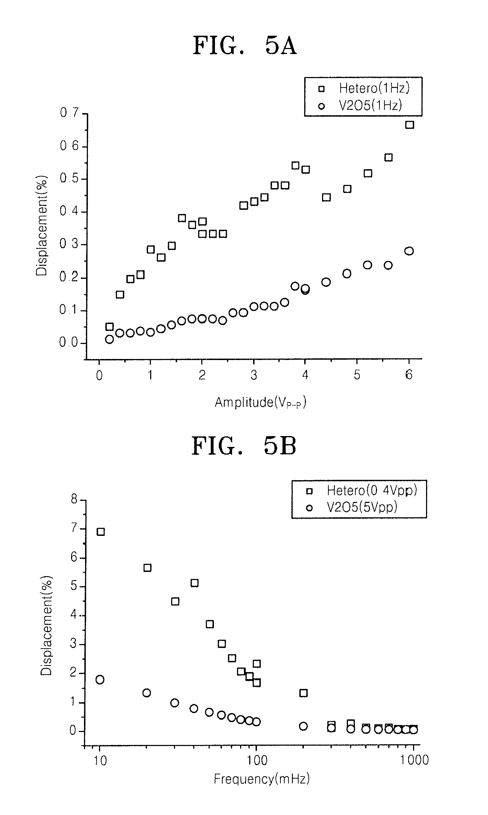

The displacement was measured as an A.C. voltage having a frequency of 1 Hz was gradually increased, and the results of normalizing the displacement are shown in FIG. 5A. In addition, the displacement of the vanadium pentoxide bucky paper of Comparative Example was measured in the same manner as in the hetero-junction membrane of Example, and the results of normalizing the displacement are shown in FIG. 5A.

As shown in FIG. 5A, the hetero-junction membrane of Example exhibited a far larger displacement at the same voltage, compared to the vanadium pentoxide bucky paper of Comparative Example. Therefore, it was confirmed that the hetero-junction membrane of Example had higher actuating efficiency than the conventional bucky paper

In addition, actuating efficiencies of the hetero-junction membrane of Example and the vanadium pentoxide bucky paper of Comparative Example were measured at voltages of 0.4 V and 5 V, respectively, as a frequency of the A.C. voltages were changed. The results are shown in FIG. 5B.

As shown in FIG. 5B, the hetero-junction membrane of Example and the vanadium pentoxide bucky paper of Comparative Example exhibited almost the same actuating efficiency in a region with a high frequency (500 to 1000 mHz), on the other hand, the hetero-junction membrane of Example exhibited a far larger displacement than the vanadium pentoxide bucky paper of Comparative Example in a region with a low frequency (less than 500 mHz). This result represents that the hetero-junction membrane of Example has much higher actuating efficiency than the conventional bucky paper, taking into consideration the applied voltage (the voltage applied to the bucky paper of Comparative Example is 12.5 times higher than the voltage applied to the hetero-junction membrane of Example).

A hetero-junction membrane according to the present invention has advantages in that actuating efficiency is much higher, the direction of actuating can be predicted and the manufacturing processes are simpler compared to a conventional bucky paper formed of a single layer.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A hetero-junction membrane comprising:
a first layer comprising first nanoparticles of a first conductive type; and
a second layer comprising second nanoparticles of a second conductive type,
wherein the first layer and the second layer are joined to each other.

2. The hetero-junction membrane of claim 1, wherein the first conductive type is n-type, and the second conductive type is p-type

3. The hetero-junction membrane of claim 1 or 2, wherein an aspect ratio of the first nanoparticles and the second nanoparticles is 30 or more.

4. The hetero-junction membrane of claim 1, 2 or 3, wherein the first nanoparticles are V₂O₅, and the second nanoparticles are carbon nanotubes.

5. The hetero-junction membrane of claim 4, wherein the carbon nanotubes are multiwall carbon nanotubes (MWCNTs).

6. A method of preparing a hetero-junction membrane, the method comprising:
preparing a first dispersion comprising first nanoparticles of a first conductive type;
preparing a second dispersion comprising second nanoparticles of a second conductive type;
removing a dispersion medium from the first dispersion to form a first layer comprising the first nanoparticles; and
positioning the second dispersion on the first layer and removing a dispersion medium from the second dispersion to form a second layer comprising the second nanoparticles.

7. The method of claim 6, wherein the first conductive type is n-type, and the second conductive type is p-type.

8. The method of claim 6 or 7, wherein the first nanoparticles are V₂O₅, and the second nanoparticles are carbon nanotubes.

9. The method of claim 6, 7 or 8, wherein the removing of the dispersion medium from the first dispersion to form the first layer comprising the first nanoparticles comprises passing the first dispersion through a filter to remove a dispersion medium therefrom.

10. The method of claim 9, wherein the positioning of the second dispersion on the first layer and the removing of the dispersion medium from the second dispersion to form a second layer comprising the second nanoparticles comprises dripping the second dispersion on the first layer in a state in which the pressure at a lower portion of the filter is lower than the pressure at an upper portion of the first layer.

11. The method of one of claims 6 to 10, further comprising baking a laminated structure of the first layer and the second layer at a temperature of 60 to 100 °C after the forming of the second layer

12. An actuator comprising the hetero-junction membrane according to one of claims 1 to 5
